# EUROPÄISCHE PATENTSCHRIFT

(11) **EP 2 873 308 B1**
(45) Veröffentlichungstag und Bekanntmachung des Hinweises auf die Patenterteilung: **23.12.2020**
(21) Anmeldenummer: 13729650.5
(22) Anmeldetag: 07.06.2013
(51) Int. Cl.: H05K 1/02, H01P 1/201, H01P 3/02

(54) **LEITERPLATTE MIT EINER STÖRWELLEN AUSSENDENDEN HOCHFREQUENZBAUGRUPPE**
PRINTED CIRCUIT BOARD EQUIPPED WITH A RADIO-FREQUENCY ASSEMBLY EMITTING INTERFERENCE WAVES
CIRCUIT IMPRIMÉ ÉQUIPÉ D'UN SOUS-ENSEMBLE À HAUTE FRÉQUENCE ÉMETTANT DES ONDES PARASITES

(30) Priorität: 10.07.2012 DE 102012106174
(43) Veröffentlichungstag der Anmeldung: 20.05.2015
(73) Patentinhaber: Endress+Hauser SE+Co. KG, 79689 Maulburg (DE)
(72) Erfinder: BLÖDT, Thomas, 79689 Maulburg (DE)
(74) Vertreter: Andres, Angelika Maria
(86) Internationale Anmeldenummer: PCT/EP2013/061808
(87) Internationale Veröffentlichungsnummer: WO 2014/009069

(56) Entgegenhaltungen:
- EP-A1- 1 783 855
- EP-A1- 1 962 377
- EP-A2- 0 647 975
- WO-A1-2011/111297
- JP-A- S58 120 301
- US-A- 4 602 229
- US-A1- 2003 080 826
- US-B1- 6 194 981
- MASSÃ D J ET AL: "A Temperature-Stable Bandpass Filter Using Dielectric Resonators", PROCEEDINGS OF THE IEEE,, Bd. 60, Nr. 6, 1. Juni 1972 (1972-06-01), Seiten 730-731, XP001402239,
- GUILLON P ET AL: "MICROSTRIP BANDSTOP FILTER USING A DIELECTRIC RESONATOR", IEE PROCEEDINGS H. MICROWAVES, ANTENNAS & PROPAGATION, INSTITUTION OF ELECTRICAL ENGINEERS. STEVENAGE, GB, Bd. 128, Nr. 3, 1. Juni 1981 (1981-06-01), Seiten 151-154, XP002127638, ISSN: 0950-107X
- VERDEYME S ET AL: "SCATTERING MATRIX OF DIELECTRIC RESONATOR COUPLED WITH TWO MICROSTRIP LINES", IEEE TRANSACTIONS ON MICROWAVE THEORY AND TECHNIQUES, IEEE SERVICE CENTER, PISCATAWAY, NJ, US, Bd. 39, Nr. 3, 1. März 1991 (1991-03-01), Seiten 517-520, XP000178851, ISSN: 0018-9480, DOI: 10.1109/22.75294
- YASUTOSHI KOMATSU ET AL: "Coupling Coefficient Between Microstrip Line and Dielectric Resonator", IEEE TRANSACTIONS ON MICROWAVE THEORY AND TECHNIQUES, IEEE SERVICE CENTER, PISCATAWAY, NJ, US, Bd. MTT-31, Nr. 1, 1. Januar 1983 (1983-01-01), Seiten 34-40, XP001402088, ISSN: 0018-9480

## Beschreibung

Die Erfindung betrifft eine Leiterplatte mit einer Leiterplattenlage, auf der eine im Betrieb hochfrequente elektromagnetische Störwellen emittierende Hochfrequenzbaugruppe und mindestens eine weitere Baugruppe, insb. eine Hochfrequenzbaugruppe, vorgesehen sind.

Derartige Leiterplatten werden in weiten Bereichen der Hochfrequenztechnik, insb. in einer Vielzahl entsprechender elektronischer Geräte, eingesetzt. Mit Hochfrequenz werden hier Frequenzen im Bereich von 3 MHz bis 300 GHz bezeichnet. Hochfrequenzbaugruppen bezeichnen Schaltungen oder Schaltungsteile, die mindestens eine bei diesen Frequenzen arbeitende Schaltungskomponente aufweisen.

Ein Beispiel solcher Geräte sind mit Mikrowellen nach dem Pulsradar-Verfahren arbeitende Füllstandsmessgeräte. Letztere dienen zur Messung eines Füllstands eines in einem Behälter befindlichen Füllgut. Sie weisen eine oberhalb des Füllguts angeordnete Antenne auf, über die im Messbetrieb periodisch kurze Mikrowellenpulse einer vorgegebenen Sendefrequenz in Richtung des Füllguts gesendet, und deren an der Füllgutoberfläche reflektierten Signalanteile nach einer vom Füllstand abhängigen Laufzeit empfangen werden. Diese Füllstandsmessgeräte weisen regelmäßig ein Hochfrequenzmodul auf, mit dem die Sendesignale erzeugt und deren reflektierten Signalanteile zur Laufzeitmessung aufbereitet und verarbeitet werden. Das Hochfrequenzmodul weist hierzu mehrere Hochfrequenzbaugruppen, wie zum Beispiel eine Sendeschaltung zur Erzeugung des Sendesignals, eine Empfangsschaltung zur Aufnahme der reflektierten Signalanteile und Verarbeitungsschaltungen zur Bestimmung der Laufzeit, auf.

Hochfrequenzbaugruppen emittieren im Betrieb in der Regel hochfrequente elektromagnetische Störwellen. Umgekehrt sind aber gerade Hochfrequenzbaugruppen häufig sehr empfindliche gegenüber hochfrequenten Störungen.

Dementsprechend ist es gerade in der Hochfrequenztechnik besonders wichtig, eine gegenseitige Störung von auf ein und derselben Leiterplatte angeordneten Hochfrequenzbaugruppen zu unterbinden.

Dabei ist zu beachten, dass hochfrequente elektromagnetische Störfelder in der Regel sowohl oberhalb der Leiterplatte als auch innerhalb einzelner Leiterplattenlagen von Leiterplatten ausbreitungsfähig sind.

Zur Reduzierung gegenseitiger Beeinträchtigungen von auf ein und derselben Leiterplatte angeordneten Hochfrequenzbaugruppen sind aus dem Stand der Technik verschiedene Lösungen bekannt.

So kann zur Reduzierung der gegenseitigen Beeinflussung von benachbarten Baugruppen ein möglichst großer räumlicher Abstand zwischen den Baugruppen vorgesehen werden. Das ist jedoch nur dann möglich, wenn hierfür genügend Platz auf der Leiterplatte zur Verfügung steht.

Des Weiteren kann zwischen den benachbarten Baugruppen eine vergleichsweise breite Kupferleiterbahn auf eine Leiterplattenlage aufgebracht werden, die eine Störung von sich oberhalb der Leiterplattenlage ausbreitenden Wellenanteilen bewirkt. Zur Störung von sich innerhalb der Leiterplattenlage ausbreitenden Wellenanteilen können entlang der Kupferleiterbahn Durchkontaktierungen vorgesehen werden, über die die Kupferleiterbahn leitend mit einer unter der Leiterplattenlage befindlichen Kupferlage verbunden sind. Dabei wirkt ein zwischen zwei Durchkontaktierungen befindlicher Abschnitt der Leiterplattenlage wie ein metallischer Hohlleiter, dessen Cut-Off Frequenz durch dessen Dimensionierung und die dielektrischen Eigenschaften der Leiterplattenlage einstellbar ist. Entsprechend sind Störsignale mit unter der Cut-Off Frequenz liegende Frequenzen im Hohlleiter nicht ausbreitungsfähig.

Ebenso ist es bekannt, die Baugruppen durch auf die Leiterplatte aufgebrachte massive metallische Stege oder aufgelötete Bleche gegeneinander abzuschirmen. Massive metallische Stege bewirkten eine hochwertige Störunterdrückung. Sie weisen jedoch den Nachteil auf, dass sie kostenintensiv sind, und bei jeder Änderung des Leiterplatten-Layouts berücksichtigt bzw. in den meisten Fällen auch in ihrer Position verändert werden müssen.

Darüber hinaus ist in der DE 10 2010 061 714 A1 beschrieben auf einen Teilbereich der Leiterplatte eine zumindest abschnittsweise metallisierte Abdeckung aufzusetzen, die den darunter befindlichen Teilbereich gegenüber elektromagnetischen Störfeldern abschirmt, denen die Leiterplattenoberseite ausgesetzt ist, und ein Austreten elektromagnetischer Störungen unterbindet.

Zusätzlich kann der Innenraum der Abdeckung mit einem leitfähigen Schaum ausgefüllt werden, in dem Mehrfachreflektionen elektromagnetischer Wellen stattfinden, die zu einer ungerichteten Bedämpfung der Störwellen führen.
Dabei ist jedoch eine Mindestdistanz von einer Viertel-Wellenlänge zwischen dem Schaum und den dazu benachbarten Hochfrequenzleitungen einzuhalten.

Auch Abdeckungen sind kostenintensiv, und die Geometrie der Abdeckung muss bei jeder Änderung des Leiterplatten-Layouts berücksichtigt bzw. in den meisten Fällen auch verändert werden.

In der US 2003/0080826 A1 ist ein Verfahren zur Verkleinerung von Mikrowellen-Schaltungen beschrieben, das darauf basiert, dass eine effektive Dielektrizitätskonstante eines dielektrischen Materials der Schaltung erhöht wird.

In der US 4, 602, 229 A, in der EP 0 647 975 A2, in der JP S 58 120301 A, in dem in Band 60, Nr. 6 auf den Seiten 730-731 der Proceedings of the IEEE vom 1. Juni 1972 veröffentlichten Artikel "A Temperatur-Stable Bandpass Filter Using Dielectric Resonators" von D.J. Masse et. al., in dem in Band 128, Nr. 3 auf den Seiten 151-154 der Proceedings of the IEEE vom 1. Juni 1981 veröffentlichten Artikel "Microstrip Bandstop Filter Using A Dielectric Resonator" von P. Guillon et. al. und in dem in den IEEE Transactions on Microwave Theory and Techniques, Band 39, Nr. 3 vom 1. März 1991 auf den Seiten 517-520 veröffentlichten Artikel "Scattering Matrix of Dielectric Resonator Coupled with Two Microstrip Lines" von S. Verdeyme und P. Guillon sind dielektrische Resonatoren umfassende Filter beschrieben.

In der US 2012/0325523 A1 sind zur Unterdrückung von elektromagnetischen Wellen zwischen Halbleiter-Baugruppen positionierbare Strukturen beschrieben, die in mehreren Lagen übereinander angeordnete leitfähige Körper umfassen.

In der EP 1 962 377 A1 sind zwei auf einer Leiterplatte angeordnete Antennen beschrieben, zwischen denen eine photonische Kristallstruktur angeordnet ist.

In der US 6, 194,981 B1 ist ein Filter beschrieben, der an eine Schlitzleitung gekoppelte Leiter umfasst.

In der EP 1 783 855 A1 ist eine Vorrichtung zum Verbinden von Übertragungsleitungen beschrieben, die an eine Schlitzleitung gekoppelte Resonatoren umfasst.

Es ist eine Aufgabe der Erfindung eine Leiterplatte, die eine Leiterplattenlage aufweist, auf der eine im Betrieb hochfrequente elektromagnetische Störwellen emittierende Hochfrequenzbaugruppe und mindestens eine weitere Baugruppe, insb. eine weitere Hochfrequenzbaugruppe, vorgesehen sind, anzugeben, bei der im Betrieb eine möglichst geringe Beeinträchtigung der Baugruppe durch Störwellen auftritt.

Die Erfindung und deren Vorteile werden nun anhand der Figuren der Zeichnung, in denen ein Ausführungsbeispiel einer ersten Variante und zwei Ausführungsbeispiele einer zweiten Variante der Erfindung dargestellt sind, näher erläutert; gleiche Teile sind in den Figuren mit gleichen Bezugszeichen versehen.
- Fig. 1 zeigt:: eine Leiterplatte auf der zwischen einer Hochfrequenzbaugruppe und einer weiteren Baugruppe dielektrische Störer angeordnet sind;
   - Fig. 2 zeigt:: eine Draufsicht auf eine Leiterplatte mit einer Leiterplattenlage in der zwischen einer Hochfrequenzbaugruppe und einer weiteren Baugruppe eine dielektrische Wellenleiteranordnung angeordnet ist;
   - Fig. 3 zeigt:: eine Metallisierung auf einer Unterseite der Leiterplattenlage von Fig. 2;
   - Fig. 4 zeigt:: Metallisierungen auf einer Ober - und einer Unterseite der Leiterplattenlage für eine breitbandigere und mit einem verbreiterten Eingang versehene Abwandlung der dielektrischen Wellenleiteranordnung von Fig. 2;
   - Fig. 5 zeigt:: einen Schnitt durch eine gemäß Fig. 4 ausgebildete Leiterplatte in Verbindung mit einer Störwelle; und
   - Fig. 6 zeigt:: einen Schnitt durch eine gemäß Fig. 4 ausgebildete Leiterplatte in Verbindung mit einer weiteren Störwelle.

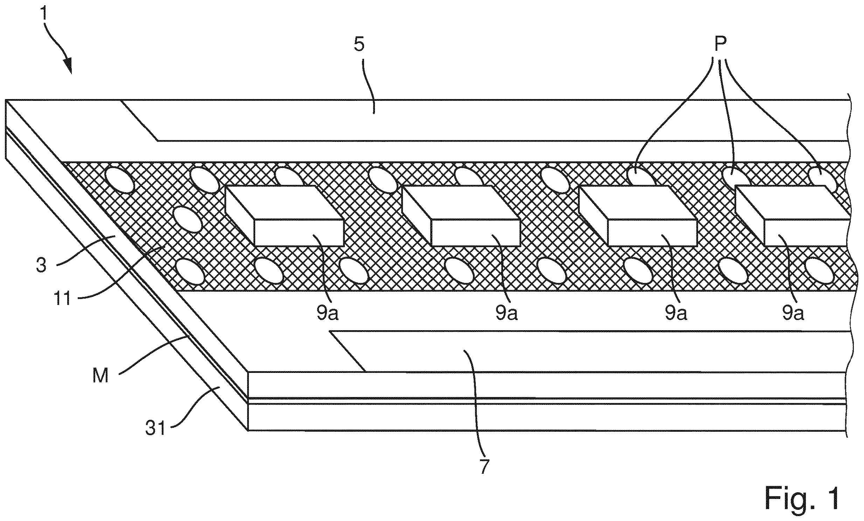

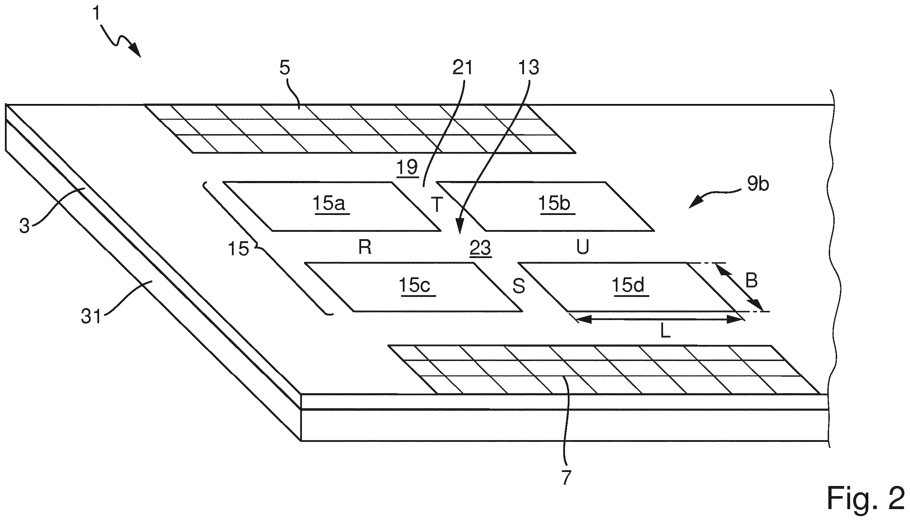

Fig. 1 und Fig. 2 zeigen jeweils eine Ansicht einer Leiterplatte 1, die eine Leiterplattenlage 3 aufweist, auf der eine - hier nur schematisch eingezeichnete- im Betrieb hochfrequente elektromagnetische Störwellen emittierende Hochfrequenzbaugruppe 5 und mindestens eine weitere - hier ebenfalls nur schematisch eingezeichnete- Baugruppe 7, insb. eine weitere Hochfrequenzbaugruppe, vorgesehen sind.

Erfindungsgemäß ist zwischen der Hochfrequenzbaugruppe 5 und der weiteren Baugruppe 7 mindestens ein dielektrischer Störer 9a, 9b vorgesehen, der eine Ausbreitung hochfrequenter elektromagnetischer Störwellen zwischen der Hochfrequenzbaugruppe 5 und der weiteren Baugruppe 7 stört. Dabei wird die Tatsache ausgenutzt das dielektrische Elemente die Ausbildung hochfrequenter elektromagnetischer Felder maßgeblich beeinflussen, und somit eine Störung der Feldausbreitung zwischen den Baugruppen bewirken. Aufgrund der Störung der Feldausbreitung wird die Übertragung elektromagnetischer Leistung zwischen der Hochfrequenzbaugruppe 5 und der weiteren Baugruppe 7 behindert, und somit eine gegenseitige Beeinträchtigung der beiden Baugruppen reduziert.

Hochfrequente elektromagnetische Wellen sind sowohl oberhalb der Leiterplattenlage 3 als auch in der Leiterplattenlage 3 ausbreitungsfähig.

Dementsprechend umfasst die Erfindung eine Variante mit mindestens einem auf einer Oberseite der Leiterplattenlage 3 angeordneten dielektrischen Störer 9a, der eine Reduktion von oberhalb der Leiterplattenlage 3 übertragenen elektromagnetischer Wellen bewirkt, und eine zweite Variante mit mindestens einem in der Leiterplattenlage 3 angeordneten dielektrischen Störer 9b, der die Ausbreitung elektromagnetischer Wellen innerhalb der Leiterplattenlage 3 behindert.

Fig. 1 zeigt ein bevorzugtes Ausführungsbeispiel der ersten Variante. Im einfachsten Fall sind die auf der Leiterplattenlage 3 angeordneten dielektrischen Störer 9a auf der Leiterplattenlage 3 angeordnete Körper, wie z.B. Würfel oder Quader, aus einem Dielektrikum.

Diese werden vorzugsweise auf eine zwischen der Hochfrequenzbaugruppe 5 und der weiteren Baugruppe 7 auf die Oberseite der Leiterplattenlage 3 aufgebrachte Leiterbahn 11, z.B. eine Kupferbahn, aufgebracht, die bereits für sich genommen ebenfalls eine Störung von sich oberhalb der Leiterplattenlage 3 ausbreitenden Wellenanteilen bewirkt.

Vorzugsweise werden anstelle einfacher dielektrischer Körper einen dielektrischen Kern aufweisende elektronische Bauteile, z.B. mit einem dielektrischen Kern ausgestattete Widerstände oder Kondensatoren, als Störer 9a eingesetzt. Dabei werden bevorzugt elektronische Bauteile eingesetzt, deren Kern eine hohe Dielektrizitätszahl aufweist. Darüber hinaus werden vorzugsweise Bauteile eingesetzt, die in einem bei der regulären Bestückung der Leiterplatte 1 ohnehin auszuführenden Bestückungsverfahren auf der Leiterplatte 1 aufgebracht werden können. Ein Beispiel hierfür sind SMD Bauteile, die auf die Leiterbahn 11 aufgelötet werden.

Zusätzlich sind entlang der Leiterbahn 11 vorzugsweise Durchkontaktierungen P vorgesehen, über die die Leiterbahn 11 leitend mit einer unter der Leiterplattenlage 3 befindlichen Metallisierung M, z.B. einer Kupferlage, verbunden ist. Dabei wirken zwischen zwei Durchkontaktierungen befindliche Abschnitte der Leiterplattenlage 3 wie metallischer Hohlleiter, deren Cut-Off Frequenz durch deren Dimensionierung und die dielektrischen Eigenschaften der Leiterplattenlage 3 einstellbar ist. Entsprechend sind Störsignale mit unter der Cut-Off Frequenz liegenden Frequenzen im metallischen Hohlleiter nicht ausbreitungsfähig.

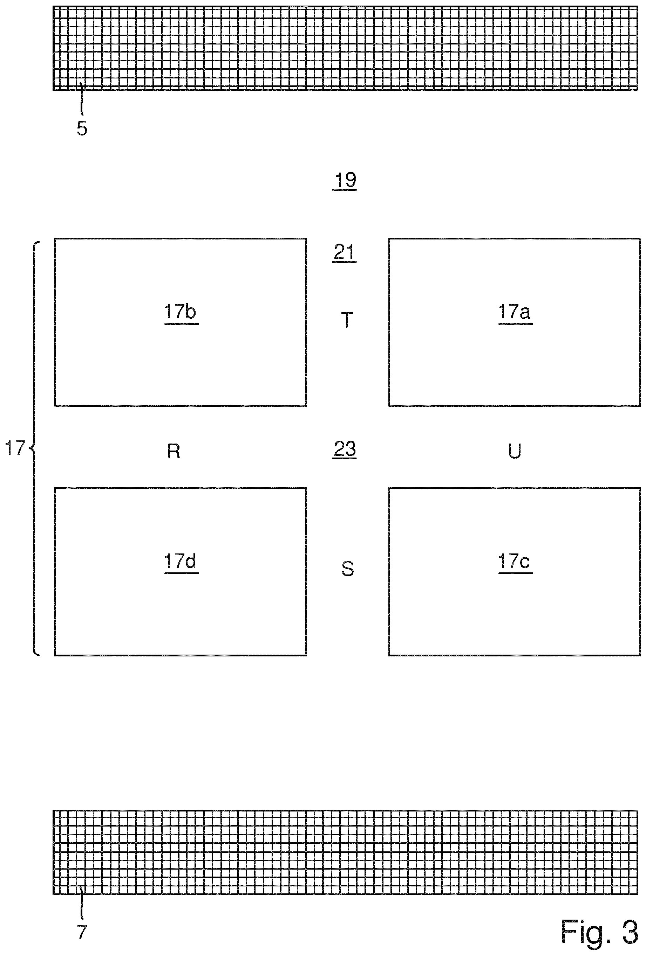

Fig. 2 und 3 zeigen ein Ausführungsbeispiel der zweiten Variante der Erfindung. Der in der Leiterplattenlage 3 angeordnete dielektrische Störer 9b umfasst vorzugsweise eine Wellenleiteranordnung 13 die mindestens ein in der Leiterplattenlage 3 verlaufendes dielektrisches Wellenleitersegment R, S, T, U aufweist.

Die Wellenleiteranordnung 13 wird vorzugsweise dadurch gebildet, dass auf der Oberseite und auf einer Unterseite der Leiterplattenlage 3 jeweils eine Metallisierung 15, 17 aufgebracht ist, die eine durch Ausnehmungen in der jeweiligen Metallisierung 15, 17 gebildete Strukturierung aufweist. Die Strukturierungen umfassen schlitzleitungsförmige Ausnehmungen, die im Zusammenwirken mit den dazwischen eingeschlossenen Bereichen der Leiterplattenlage 3 die Wellenleiteranordnung 13 bilden. Dabei weisen die Metallisierungen 15, 17 auf der Ober- und der Unterseite im Bereich der dielektrischen Wellenleitersegmente R, S, T, U formgleiche übereinander liegende schlitzleitungsförmige Ausnehmungen auf, durch die Anordnung, Geometrie und Verlauf der durch die Metallisierungen 15, 17 begrenzten die dielektrischen Wellenleitersegmente R, S, T, U bildenden Bereiche der Leiterplattenlage 3 vorgegeben sind. Die entsprechende Strukturierung der auf der Oberseite aufgebrachten Metallisierung 15 ist in der in Fig. 2 dargestellten Draufsicht zu sehen. Die Strukturierung der auf der Unterseite der Leiterplattenlage 3 aufgebrachten Metallisierung 17 ist in Fig. 3 dargestellt.

Das Aufbringen strukturierter Metallisierungen ist ein Arbeitsschritt, der ohnehin bei der Herstellung von Leiterplatten 1 standardmäßig ausgeführt wird. Entsprechend ist auch die Erzeugung komplexerer Wellenleiteranordnungen 13 regelmäßig ohne einen zusätzlichen Arbeitsschritt kostengünstig möglich.

Zwischen der Hochfrequenzbaugruppe 5 und der Wellenleiteranordnung 13 ist vorzugsweise ein metallisierungsfreier Bereich 19 vorgesehen, in dem auf der Unterseite der Leiterplattenlage 3 und vorzugsweise auch auf der Oberseite Leiterplattenlage 3 keine Metallisierung aufgebracht ist. Hierdurch wird erreicht, dass dieser Bereich 19 der Leiterplattenlage 3 als ebener dielektrischer Wellenleiter wirkt, über den sich in der Leiterplattenlage 3 ausbreitende elektromagnetische Wellen in Richtung des dielektrischen Störers 9b geführt werden.

Grundsätzlich bewirkt bereits ein einziges vorzugsweise quer zur Ausbreitungsrichtung der Störwellen verlaufendes dielektrisches Wellenleitersegment R, U eine Störung der Ausbreitung elektromagnetischer Wellen innerhalb der Leiterplattenlage 3, und damit eine Reduktion gegenseitiger Beeinträchtigungen benachbarter Baugruppen.

Dabei bezeichnet die Ausbreitungsrichtung eine von der Störwellenemission der auf der Leiterplatte 1 bzw. in der Leiterplatte 1 vorgesehenen Komponenten abhängige Richtung, in der sich ohne Maßnahmen zur Störunterdrückung diejenigen Störwellen ausbreiten würden, die die größte oder zumindest eine wesentliche Beeinträchtigung einer anderen Komponente bewirken würden. Dabei wird vorzugsweise auch die Empfindlichkeit der anderen Komponenten gegenüber elektromagnetischen Störungen mit berücksichtigt. Baugruppen emittieren Störwellen regelmäßig in alle Raumrichtungen oder zumindest unter einem großen Öffnungswinkel. Dementsprechend ist die Ausbreitungsrichtung als eine Hauptrichtung zu verstehen, in der die emittierte Störstrahlung ohne Maßnahmen zu deren Unterdrückung den größten negativen Einfluss ausüben würde.

Im vorliegenden Beispiel wird angenommen, dass diese Störwellen von der Hochfrequenzbaugruppe 5 ausgehen, und die weitere Baugruppe 7 empfindlich gegenüber Störwellen ist. Dementsprechend verläuft die hier relevante Ausbreitungsrichtung der Störwellen im Wesentlichen in Richtung einer gedachten Verbindungslinie zwischen der Hochfrequenzbaugruppe 5 und der weiteren Baugruppe 7.

Vorzugsweise umfasst die Wellenleiteranordnung 13 jedoch nicht nur ein einziges Wellenleitersegment, sondern ein nachfolgend im Detail beschriebenes System aus mehreren miteinander verbundenen dielektrischen Wellenleitersegmenten R, S, T, U. Das bietet den Vorteil, dass das Wellenleitersystem derart ausgebildet werden kann, dass damit nicht nur eine Störung der Wellenausbreitung zwischen den beiden Baugruppen bewirkt wird, sondern darüber hinaus auch eine zumindest teilweise Auslöschung der Störwellen erzielt werden kann.

Dabei umfasst die Wellenleiteranordnung 13 vorzugsweise einen der Hochfrequenzbaugruppe (5) zugewandten Eingang 21, über den sich in der Leiterplattenlage 3 ausbreitende Störwellen in das Wellenleitersystem eindringen.

Das Wellenleitersystem umfasst vorzugsweise vier über eine Verzweigung 23 miteinander verbundene Wellenleitersegmente R, S, T, U, von denen zwei gradlinig über die Verzweigung 23 miteinander verbunden sind und quer zur Ausbreitungsrichtung der Störwellen verlaufen, und zwei gradlinig über die Verzweigung 23 miteinander verbunden sind und parallel zur Ausbreitungsrichtung der Störwellen verlaufen. Damit treffen alle vier Wellenleitersegmente R, S, T, U in der Verzweigung 23 zusammen.

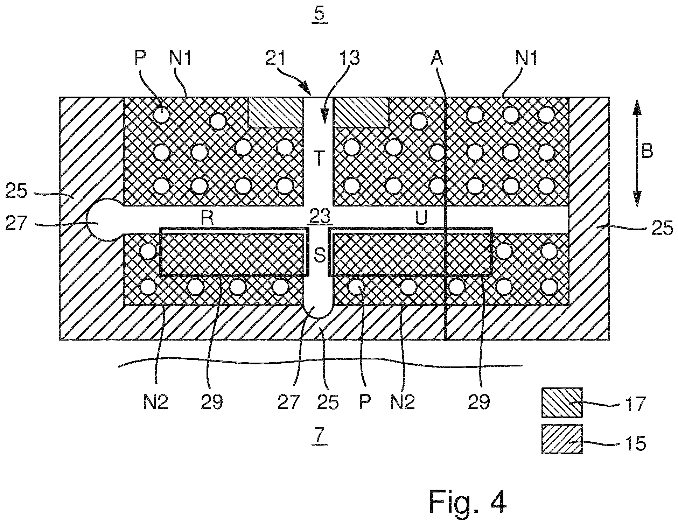

Der Eingang 21 kann im einfachsten Fall durch das der Hochfrequenzbaugruppe 5 zugewandte Ende des Wellenleitersegments T gebildet sein. Diese Ausführungsform ist in den Figuren 2 und 3 dargestellt. Vorzugsweise wird jedoch eine Eingangsform gewählt, die einen reflektionsarmen Übergang der über den metallisierungsfreien Bereich 19 breitseitig dielektrisch geführten Wellen in das Wellenleitersegment T bewirkt. Dies wird beispielsweise dadurch erreicht, dass die den Wellenleiter T vorgebende schlitzleitungsförmige Ausnehmung der auf der Unterseite der Leiterplattenlage 3 aufgebrachten Metallisierung 17 endseitig in Richtung der Hochfrequenzbaugruppe 5 verbreitert ist. Dies kann eine sprunghafte Verbreiterung sein. Fig. 4 zeigt hierzu die Metallisierungen 15, 17 einer entsprechenden Abwandlung der Leiterplatte 1 von Fig. 2 und 3, wobei die beiden Metallisierungen 15, 17 übereinander und durch unterschiedlich ausgerichtete Schraffierungen unterscheidbar dargestellt sind.

Alternativ kann auch eine andere Verbreiterungsform, z.B. eine trichter- oder trompetenförmig in Richtung der Hochfrequenzbaugruppe 5 breiter werdende Verbreiterung, vorgesehen werden.

Im Betrieb dringt zumindest ein Teil der von der Hochfrequenzbaugruppe 5 ausgehenden sich in der Leiterplattenlage 3 ausbreitenden elektromagnetischen Störwellen über den Eingang 21 in die Wellenleiteranordnung 13 ein, und wird über den Wellenleiter T zu Verzweigung 23 geführt, wo er auf drei sich in den übrigen drei Wellenleitersegmentes R, S, U ausbreitende Teilwellen aufgeteilt wird. Jede dieser Teilwellen wird am Ende des jeweiligen Wellenleitersegments R, S, U zur Verzweigung 23 zurück reflektiert. Dabei wird ein zumindest ein Teil der reflektierten Teilwellen über die Verzweigung 23 in das Wellenleitersegment T zurück reflektiert. Hiervon wird wiederum zumindest ein Teil an dem der Hochfrequenzbaugruppe 5 zugewandten Ende des Wellenleitersegments T bzw. am Eingang 21 erneut in Richtung der Verzweigung 23 zurück reflektiert.

Insgesamt tritt hierdurch innerhalb der Wellenleiteranordnung 13 eine Überlagerung der eingehenden und der reflektierten Teilwellen auf, durch die bei entsprechender frequenzangepasster Dimensionierung der Längen der einzelnen dielektrischen Wellenleitersegmente R, S, T, U eine Auslöschung eines Teils der eingehenden Leistung durch destruktive Interferenz bewirkt wird.

Die Dimensionierung wird hierzu vorzugsweise in Abhängigkeit von einer vorgegebenen Hauptfrequenz der von der Hochfrequenzbaugruppe 5 ausgehenden elektromagnetischen Störwellen festgelegt.

Dabei weisen die quer zur Ausbreitungsrichtung verlaufenden Wellenleitersegment R und U eine Länge auf, die gleich der Hälfte der Wellenlänge der mit der Hauptfrequenz ausgesendeten Störwellen im jeweiligen Wellenleitersegment R, U ist, und die parallel zur Ausbreitungsrichtung verlaufenden Wellenleitersegmente S und T weisen jeweils eine Länge auf, die gleich einem Viertel der Wellenlänge der mit der Hauptfrequenz ausgesendeten Störwellen im jeweiligen Wellenleitersegment S, T ist. Hierdurch wird insb. im Bereich der Verzweigung 23 destruktive Interferenz erzielt. Letztere ist aufgrund der hierfür erforderlichen frequenzabhängigen Dimensionierung der Wellenleiteranordnung 13 auf ein schmales die Hauptfrequenz umgebendes Frequenzband begrenzt.

Bei Verwendung eines verbreiterten Eingangs 21 ist der eingangsseitig im Wellenleitersegment T in Richtung der Verzweigung 23 zurück reflektierte Anteil geringer, als der an den Enden der Wellenleitersegmente R, S, U reflektierte Anteil. Dies wird in Bezug auf die gewünschte destruktive Interferenz vorzugsweise dadurch ausgeglichen, dass die quer zur Ausbreitungsrichtung verlaufenden Wellenleitersegmente R, U derart ausgebildet werden, dass sie eine geringfügig größere Impedanz aufweisen, als die gradlinig mit dem Eingang 21 verbundenen Wellenleitersegmente S, T. Hierdurch wird bewirkt, dass über die Verzweigung 23 ein geringfügig größerer Anteil in die Wellenleitersegmente S, T geleitet wird. Dabei liegt der vorzusehende Impedanzunterschied regelmäßig in der Größenordnung von wenigen Prozent, z.B. im Bereich von 5 %.

Die Metallisierungen 15, 17 auf der Ober- und der Unterseite der Leiterplattenlage 3 bestehen bei dem in den Figuren 2 und 3 darstellten Ausführungsbeispiel aus vier voneinander beabstandeten rechteckförmigen Metallflächen 15a, 15b, 15c, 15d, 17a, 17b, 17c, 17d deren senkrecht zur Ausbreitungsrichtung verlaufende Länge L der Länge der Wellenleitersegmente R bzw. U entspricht, und deren Breite B der Länge der Wellenleitersegmente S bzw. T entspricht.

Da die einzelnen Metallflächen 15a, 15b, 15c, 15 und 17a, 17b, 17c, 17d der Metallisierungen 15, 17 räumlich getrennt voneinander sind, bewirken sie ein galvanische Trennung der zugehörigen Leiterplattenlagenbereiche, die zum Beispiel für den Explosionsschutz, zur Verhinderung von Masseschleifen, oder zur Realisierung unterschiedlicher Bezugspotentiale für die Hochfrequenzbaugruppe 5 und die weitere Baugruppe 7 genutzt werden kann.

In Anwendungen in denen eine galvanische Trennung nicht erwünscht oder nicht erforderlich ist, werden sind vorzugsweise die einzelnen Metallflächen 17a, 17b, 17c, 17d einer der Metallisierungen 17 der Leiterplattenlage 3 durch Brücken 25 leitend miteinander verbunden. Die Brücken 25 werden hierzu flächig außerhalb der Wellenleiteranordnung 13 auf der entsprechenden Seite der Leiterplattenlage 3 aufgebracht. Diese Abwandlung der in Fig. 2 und 3 dargestellten Leiterplatte 1 ist in dem in Fig. 4 gezeigten Ausführungsbeispiel bei der auf der Unterseite der Leiterplattenlage 3 aufgebrachten Metallisierung 17 vorgesehen. Die Brücken 25 bieten den Vorteil, dass die einzelnen Metallflächen 17a, 17b, 17c, 17d hierdurch auf dem gleichen Potential liegen, und somit eine homogenere Begrenzung für die Elemente der dielektrischen Wellenleiteranordnung 13 bilden. Grundsätzlich können derartige Brücken bei jeder der Metallisierungen 15, 17 vorgesehen sein. Eine im Hinblick auf die gewünschte destruktive Interferenz breitbandigere Wellenleiteranordnung 13 wird jedoch erzielt, indem nur eine der beiden auf die Leiterplattenlage 3 aufgebrachten Metallisierungen 15, 17 mit Brücken 25 versehen wird. Dabei wird im Hinblick auf die Breitbandigkeit vorzugsweise diejenige Metallisierung 17 mit Brücken 25 versehen, die auf deren von der Leiterplattenlage 3 abgewandten Seite an die die größere Dielektrizitätszahl aufweisende Schicht angrenzt. In dem dargestellten Ausführungsbeispiel ist das die auf einer weiteren Leiterplattenlage 31 aufliegende Metallisierung 17 auf der Unterseite der Leiterplattenlage 3, da die Leiterplattenlage 3 hier die oberste Lage der Leiterplatte 1 bildet, über der sich die Umgebungsatmosphäre befindet, die eine geringere Dielektrizitätszahl aufweist, als die weitere Leiterplattenlage 31. Bei mehrlagigen Leiterplatten, bei denen in mehreren Lagen dielektrische Wellenleiteranordnungen vorgesehen sind, ist vorzugsweise mindestens eine und höchstens jede zweite Metallisierung mit Brücken versehen.

Das oben beschriebene Auftreten von destruktiver Interferenz ist aufgrund der hierfür erforderlichen frequenzabhängigen Dimensionierung der Wellenleiteranordnung 13 auf ein schmales die Hauptfrequenz umgebendes Frequenzband begrenzt.

Dieses Frequenzband wird vorzugsweise verbreitert, indem eines der beiden quer zur Ausbreitungsrichtung verlaufenden Wellenleitersegmente R, U und das parallel zur Ausbreitungsrichtung auf der von der Hochfrequenzbaugruppe 5 abgewandten Seite der Verzweigung 23 verlaufende Wellenleitersegment S derart ausgebildet sind, dass sie auf deren Oberseite eine geringfügig geringere Länge aufweisen, als auf deren Unterseite. Dies ist in dem in Fig. 4 gezeigten Ausführungsbeispiel bei den Wellenleitersegmenten R und S vorgesehen. Hierzu weisen die das Wellenleitersegment R begrenzenden Metallflächen 15a, 15c eine geringfügig kleinere Länge auf, als die entsprechenden Länge der darunter befindlichen Metallflächen 17a, 17c der auf der Unterseite aufgebrachten Metallisierung 17. Genauso weisen die das Wellenleitersegment S begrenzenden Metallflächen 15c, 15d eine geringfügig kleinere Breite auf, als die darunter befindlichen Metallflächen 17c, 17d der auf der Unterseite aufgebrachten Metallisierung 17.

Darüber hinaus weisen die Enden dieser beiden Wellenleitersegmente R, S zur weiteren Verbreiterung des Frequenzbands auf deren Unterseiten vorzugsweise einen kreisförmigen Abschluss 27 auf. Auch dies ist in Fig. 4 dargestellt. Dabei wird der unterseitige kreisförmige Abschluss 27 durch eine entsprechende kreisförmige, hier innerhalb der entsprechenden beiden Brücken 25 angeordneten, Ausnehmung in der Metallisierung 17 der Unterseite der Leiterplattenlage 3 bewirkt.

Neben der Störung und der teilweisen Vernichtung von sich innerhalb der Leiterplattenlage 3 ausbreitenden Störwellen bewirkt die Wellenleiteranordnung 13 zusätzlich auch eine Störung von sich auf der Leiterplattenlage 3 ausbreitenden Störwellen.

Dabei bildet der der Hochfrequenzbaugruppe 5 zugewandte Rand der auf der Oberseite der Leiterplattenlage 3 aufgebrachten Metallisierung 15 für diese Störwellen eine Kante N1, an der ein Teil dieser Störwellen reflektiert wird. Genauso wird in umgekehrter Richtung ein Teil der gegebenenfalls von der weiteren Baugruppe 7 ausgehenden sich auf der Oberseite der Leiterplattenlage 3 in Richtung der Hochfrequenzbaugruppe 5 ausbreitenden Störwellen an der der weiteren Baugruppe 7 zugewandten Kante N2 der Metallisierung 15 der Oberseite reflektiert. In beiden Fällen bewirkt die jeweilige Kante N1, N2 eine Reduktion der gegenseitigen Beeinträchtigung der beiden Baugruppen.

Darüber hinaus werden sich auf der Oberseite der Leiterplattenlage 3 ausbildende elektromagnetische Felder teilweise über die Oberseite der Leiterplattenlage 3 in die Wellenleiteranordnung 13 eintreten. Auch hierdurch wird die gegenseitige Beeinträchtigung der beiden Baugruppen reduziert. Dabei hängt der Anteil, der auf diese Weise von der Wellenleiteranordnung 13 aufgenommenen Störwellen maßgeblich von der Breite B der an die jeweilige Kante N1, N2 angrenzenden Metallflächen 15a, 15b, 15c, 15d und der Wellenlänge der Störwellen oberhalb der Leiterplattenlage 3 ab. Diese Breiten B geben zugleich auch die Längen der parallel zur Ausbreitungsrichtung verlaufenden Wellenleitersegmente T, S vor. Entsprechend werden die Breiten B vorzugsweise derart vorgegeben, dass die insgesamt - also sowohl durch von oben in die Wellenleiteranordnung 13 eintretenden als auch durch die in der Wellenleiteranordnung 13 destruktiv interferierenden Störwellenanteile - bewirkte Störunterdrückung maximal ist.

Alternativ können natürlich auch Wellenleiteranordnungen eingesetzt werden, die in anderer Weise mit einander verbundene bzw. in anderer Weise angeordnete Wellenleitsegmente aufweisen.

Vorzugsweise sind auch bei dieser Variante der Erfindung in Fig. 4 dargestellte Durchkontaktierungen P vorgesehen, über die die Metallflächen 15a, 15b, 15c, 15d der Metallisierung 15 auf der Oberseite der Leiterplattenlage 3 leitend mit den darunter befindlichen Metallflächen 17a, 17b, 17c, 17d der Metallisierung 17 der Unterseite der Leiterplattenlage 3 verbunden sind. Auch hier wirkt der jeweils zwischen zwei Durchkontaktierungen befindliche Abschnitt der Leiterplattenlage 3 wie ein metallischer Hohlleiter, dessen Cut-Off Frequenz durch dessen Dimensionierung und die dielektrischen Eigenschaften der Leiterplattenlage 3 einstellbar ist. Entsprechend sind Störsignale mit unter der Cut-Off Frequenz liegenden Frequenzen im metallischen Hohlleiter nicht ausbreitungsfähig.

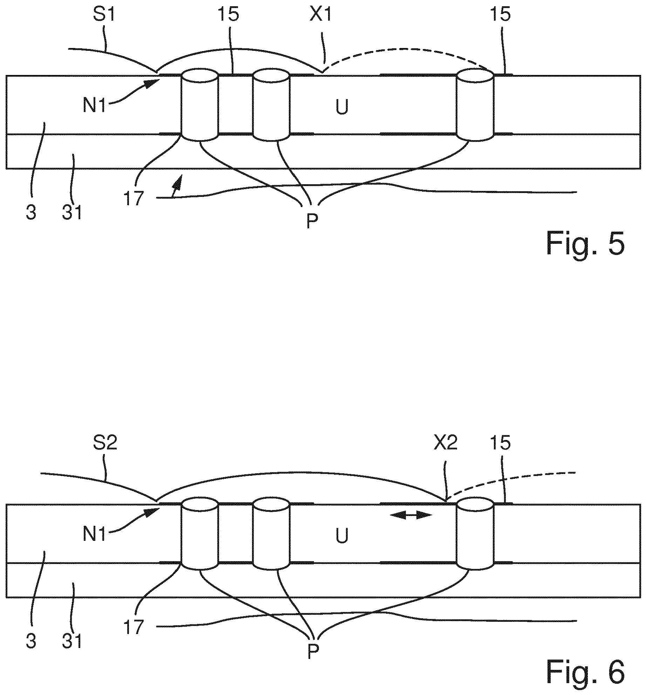

Grundsätzlich können die Durchkontaktierungen P überall dort über die Metallflächen 15a, 15b, 15c, 15d der Metallisierung 15 der Oberseite der Leiterplattenlage 3 verteilt angeordnet werden, unter denen sich auf der Unterseite der Leiterplattenlage 3 eine der Metallflächen 17a, 17b, 17c, 17d der Metallisierung 17 der Unterseite der Leiterplattenlage 3 befindet. Dabei werden jedoch vorzugsweise die an die quer zur Ausbreitungsrichtung verlaufenden Wellenleitersegmente R und U auf deren der weiteren Baugruppe 7 zugewandten Seite angrenzenden Bereiche 29 ausgespart. D.h. in diesen beiden Bereichen 29 der Metallflächen 15c, 15d werden vorzugsweise keine Durchkontaktierungen P vorgesehen. Die durchkontaktierungsfreien Bereiche 29 sind in Fig. 4 durch einen Rahmen optisch hervorgehoben. Sie bieten den Vorteil, dass hierdurch der Anteil der sich oberhalb der Leiterplattenlage 3 ausbreitenden Störwellen, der in die Wellenleiteranordnung 13 eindringt vergrößert wird. Dies ist nachfolgend anhand der beiden Figuren 5 und 6 erläutert, die jeweils einen Schnitt durch die in Fig. 4 dargestellte Leiterplatte 1 entlang einer parallel zur gedachten Verbindungslinie zwischen der Hochfrequenzbaugruppe 5 und der weiteren Baugruppe 7 durch das Wellenleitersegment U verlaufenden Schnittebene A zeigen. In beiden Figuren 5, 6 ist jeweils eine oberhalb der Leiterplattenlage 3 von der Hochfrequenzbaugruppe 5 in Richtung der weiteren Baugruppe 7 über die Kante N1 hinwegtretende Störwelle S1, S2 dargestellt. Die in Fig. 5 dargestellte Störwelle S1 weist eine höhere Frequenz und damit eine kürzere Wellenlänge auf, als die in Fig. 6 dargestellte Störwelle S2. In beiden Beispielen trifft die Störwelle S1, S2 an einem von deren Wellenlänge abhängigen Auftreffpunkt X1, X2 auf die Leiterplattenlage 3 auf. Liegt dieser Auftreffpunkt X1, wie in Fig. 5 dargestellt, im Bereich des Wellenleitersegments U, so tritt die Störwelle S1 zumindest teilweise in die Wellenleiteranordnung 13 ein, und bewirkt damit keine Störung der weiteren Baugruppe 7 mehr.

Liegt der Auftreffpunkt X2, wie in Fig. 6 dargestellt, innerhalb des durchkontaktierungsfreien Bereichs 29, so bildet sich eine Feldverteilung aus, durch die ein Teil der Störwelle S2 in das Wellenleitersegment U zurück geführt wird. Dies ist in Fig. 6 durch einen Pfeil angedeutet. Dabei ist der zum Wellenleitersegment U zurück geführte Teil ist umso größer, je näher der Auftreffpunkt X2 am dielektrischen Wellenleiter U liegt. In Ausbreitungsrichtung hinter der ersten Durchkontaktierung P auftreffende Störwellen können jedoch nicht in die dielektrische Wellenleiteranordnung 13 zurückgeführt werden.

Auch wenn die Wellenleiteranordnung 13 insb. über die Positionierung des Eingangs 21 und der durchkontaktierungsfreien Bereiche 29 darauf hin optimiert ist, eine Übertragung von Störwellen von der Hochfrequenzbaugruppe 5 in Richtung der weiteren Baugruppe 7 zu reduzieren, so wirkt sie zusätzlich auch in umgekehrter Richtung. D.h. auch eine Übertragung hochfrequenter Störwellen von der weiteren Baugruppe 7 in Richtung der Hochfrequenzbaugruppe 5 wird durch die Wellenleiteranordnung 13 wird auf die oben beschriebenen Weisen gestört.

Je nach sonstigem Aufbau der Leiterplatte 1 bzw. gewünschter Störunterdrückung, können weitere Wellenleiteranordnungen 13 in der Leiterplattenlage 3 vorgesehen werden. Die Wellenleiteranordnungen 13 können z.B. derart einem orthogonalen oder hexagonalen Raster über die Leiterplatte 1 verteilt angeordnet werden, dass sie eine oder mehrere innerhalb eines Rasterfeldes angeordnete Baugruppen, insb. Hochfrequenzbaugruppen, nahezu allseitige umgeben.

Bei mehrlagigen Leiterplatten können die Wellenleiteranordnungen 13 sowohl in der obersten Leiterplattenlage 3 auch in einer oder mehreren inneren Leiterplattenlagen 3 angeordnet sein.

Darüber hinaus können die beiden Varianten der Erfindung, also einer oder mehrere oberhalb der Leiterplattenlage 3 aufgebrachte dielektrische Störer 9a, sowie einer oder mehrere in der Leiterplattenlage 3 angeordnete dielektrische Störer 9b, auch in Kombination mit einander räumlich benachbart zueinander in einer Leiterplatte 1 eingesetzt werden.

Bei beiden Varianten bestehen die Leiterplattenlagen 3 auf denen bzw. in denen dielektrische Störer 9a, 9b vorgesehen sind, aus einem für Hochfrequenzanwendungen geeigneten Material, wie z.B. Keramik. Erfindungsgemäß ist unter diesen Leiterplattenlagen 3 jeweils eine weitere Leiterplattenlage 31 vorgesehen, die aus einem Material besteht, das hochfrequente elektromagnetische Wellen stark bedämpft. Ein Beispiel hierfür sind unter der Materialbezeichnung FR 4 bekannte mit Expoxidharz getränkte Glasfasermatten. Hierdurch wird zusätzlich ein gegebenenfalls unter der Leiterplattenlage 3 hindurch übertragener Anteil an Störwellen sehr viel stärker gedämpft, als dies in für Hochfrequenzanwendungen bevorzugt verwendeten Leiterplattenmaterialien der Fall wäre. Die erfindungsgemäße Störunterdrückung durch auf und/oder in der Leiterplattenlage 3 vorgesehene dielektrische Störer 9a, 9b weist den Vorteil auf, dass zur Erzeugung der dielektrischen Störer 9a, 9b ausschließlich Arbeitsgänge benötigt werden, die in nahezu jedem Leiterplattenherstellungsprozess ohnehin standardmäßig eingesetzt und verwendet werden. Dementsprechend können diese Störunterdrückungsmaßnahme kostengünstig vorgenommen werden. Darüber hinaus sind dielektrische Störer 9a, 9b äußerst flexibel im Hinblick auf möglicher Weise erforderlich werden zukünftige Änderungen des Layouts der Leiterplatte 1, da die Störer 9a, 9b im Rahmen des Herstellungsprozess nahezu beliebig entsprechend den Erfordernissen des geänderten Layouts auf bzw. in der Leiterplattenlage 3 positioniert werden können.
- 1: Leiterplatte
- 3: Leiterplattenlage
- 5: Hochfrequenzbaugruppe
- 7: Baugruppe
- 9a: dielektrischer Störer
- 9b: dielektrischer Störer
- 11: Leiterbahn
- 13: Wellenleiteranordnung
- 15: Metallisierung
- 17: Metallisierung
- 19: metallisierungsfreier Bereich
- 21: Eingang
- 23: Verzweigung
- 25: Brücke
- 27: kreisförmiger Abschluss
- 29: durchkontaktierungsfreier Bereich
- 31: weitere Leiterplattenlage

## Patentansprüche

1. Leiterplatte (1) mit
- einer Leiterplattenlage (3) auf der eine im Betrieb hochfrequente elektromagnetische Störwellen emittierende Hochfrequenzbaugruppe (5) und mindestens eine weitere Baugruppe (7), insbesondere eine weitere Hochfrequenzbaugruppe, vorgesehen sind, **dadurch gekennzeichnet, dass**
- zwischen der Hochfrequenzbaugruppe (5) und der weiteren Baugruppe (7) mindestens ein dielektrischer Störer (9a, 9b) vorgesehen ist, der eine Ausbreitung hochfrequenter elektromagnetischer Störwellen zwischen der Hochfrequenzbaugruppe (5) und der weiteren Baugruppe (7) stört, und
- unter der Leiterplattenlage (3) eine weitere Leiterplattenlage (31) aus einem hochfrequente elektromagnetische Wellen bedämpfenden Material, insbesondere aus Expoxidharz getränkte Glasfasermatten, vorgesehen ist.

2. Leiterplatte nach Anspruch 1, **dadurch gekennzeichnet, dass** mindestens ein dielektrischer Störer (9a) ein auf einer Oberseite der Leiterplattenlage (3) aufgebrachter Körper aus einem Dielektrikum, insbesondere ein dielektrischer Kern eines auf einer metallischen Leiterbahn (11) auf der Oberseite der Leiterplattenlage (3) aufgebrachten Bauteils, insbesondere eines Widerstands oder eines Kondensators, ist.

3. Leiterplatte nach Anspruch 1, **dadurch gekennzeichnet, dass** mindestens ein dielektrischer Störer (9b) eine in der Leiterplattenlage (3) angeordnete dielektrische Wellenleiteranordnung (13) ist.

4. Leiterplatte nach Anspruch 3, **dadurch gekennzeichnet, dass** die dielektrische Wellenleiteranordnung (13) mindestens ein quer zu einer Ausbreitungsrichtung der Störwellen verlaufendes Wellenleitersegment (R, U) aufweist.

5. Leiterplatte nach Anspruch 3, **dadurch gekennzeichnet, dass** die Wellenleiteranordnung (13) über eine Verzweigung (23) miteinander verbundene Wellenleitersegmente (R, S, T, U) umfasst,
- von denen zwei gradlinig über die Verzweigung (23) miteinander verbunden sind und quer zu einer Ausbreitungsrichtung der Störwellen verlaufen, und
- von denen zwei gradlinig über die Verzweigung miteinander verbunden sind und parallel zur Ausbreitungsrichtung der Störwellen verlaufen.

6. Leiterplatte nach Anspruch 5, **dadurch gekennzeichnet, dass**
- im Betrieb über das der Hochfrequenzbaugruppe (5) zugewandte, parallel zur Ausbreitungsrichtung der Störwellen verlaufende Wellenleitersegment (T) in die Wellenleiteranordnung (13) eintretende Störwellen an der Verzweigung (23) in sich in den übrigen Wellenleitersegmenten (R, S, U) ausbreitende Teilwellen aufgeteilt werden,
- diese Teilwellen an den Enden der Wellenleitersegmente (R, S, T, U) reflektiert werden, und
- die Wellenleitersegmente (R, S, T, U) in Abhängigkeit von einer vorgegebenen Hauptfrequenz der Störwellen vorgegebene Längen aufweisen, bei denen sich Teilwellen eintretender Störwellen der Hauptfrequenz mit an den Enden der Wellenleitersegmente (R, S, T, U) reflektierten Teilwellen in der Wellenleiteranordnung (13) destruktiv überlagern.

7. Leiterplatte nach Anspruch 6, **dadurch gekennzeichnet, dass**
- die quer zur Ausbreitungsrichtung der Störwellen verlaufenden Wellenleitersegmente (R, U) eine Länge aufweisen, die einer halben Wellenlänge der die Hauptfrequenz aufweisenden Störwellen in diesen Wellenleitersegmenten (R, U) entspricht, und
- die parallel zur Ausbreitungsrichtung der Störwellen verlaufenden Wellenleitersegmente (S, T) eine Länge aufweisen, die einem Viertel der Wellenlänge der die Hauptfrequenz aufweisenden Störwellen in diesen Wellenleitersegmenten (S, T) entspricht.

8. Leiterplatte nach Anspruch 6, **dadurch gekennzeichnet, dass** die Wellenleiteranordnung (13) einen der Hochfrequenzbaugruppe (5) zugewandten Eingang (21) aufweist, der in dem der Hochfrequenzbaugruppe (5) zugewandten, parallel zur Ausbreitungsrichtung der Störwellen verlaufenden Wellenleitersegment (T) mündet.

9. Leiterplatte nach Anspruch 6, **dadurch gekennzeichnet, dass** die gradlinig mit dem Eingang (23) verbundenen Wellenleitersegmente (S, T) eine geringere Impedanz aufweisen als die übrigen Wellenleitersegmente (R, U).

10. Leiterplatte nach Anspruch 3, **dadurch gekennzeichnet, dass** die Wellenleiteranordnung (13) durch einen Bereich der Leiterplattenlage (3) gebildet ist, in dem
- auf der Oberseite und auf einer Unterseite der Leiterplattenlage (3) jeweils eine Metallisierung (15, 17) aufgebracht ist,
- die Metallisierungen (15, 17) jeweils eine durch Ausnehmungen in der Metallisierung gebildete Strukturierung aufweisen, und
- die Strukturierungen im Zusammenwirken mit den dazwischen eingeschlossenen Bereichen der Leiterplattenlage (3) die Wellenleiteranordnung (13) bilden.

11. Leiterplatte nach Anspruch 10, **dadurch gekennzeichnet, dass** die Metallisierungen (15, 17) aus voneinander räumlich getrennten Metallflächen (15a, 15b, 15c, 15d, 17a, 17b, 17c, 17d) bestehen.

12. Leiterplatte nach Anspruch 10, **dadurch gekennzeichnet, dass** die Metallflächen (17a, 17b, 17c, 17d) einer der Metallisierungen (17), insb. die Metallflächen (17a, 17b, 17c, 17d) der auf der Unterseite der Leiterplattenlage (3) vorgesehenen Metallisierung (17), über außerhalb der Wellenleiteranordnung (13) auf der Leiterplattenlage (3) aufgebrachte Brücken (25) leitend miteinander verbunden sind.

13. Leiterplatte nach Anspruch 8 und 10, **dadurch gekennzeichnet, dass** der Eingang (21) durch Ausnehmungen in der Metallisierung (17) auf der Unterseite der Leiterplattenlage (3) gebildet ist.

14. Leiterplatte nach Anspruch 5, **dadurch gekennzeichnet, dass** eines der quer zur Ausbreitungsrichtung der Störwellen verlaufenden Wellenleitersegmente (R) und das auf der von der Hochfrequenzbaugruppe (5) abgewandten Seite der Verzweigung (23) parallel zur Ausbreitungsrichtung verlaufende Wellenleitersegment (S) derart ausgebildet sind, dass sie auf deren Oberseite eine geringfügig geringere Länge aufweisen, als auf deren Unterseite.

15. Leiterplatte nach Anspruch 14, **dadurch gekennzeichnet, dass** das quer zur Ausbreitungsrichtung der Störwellen verlaufende Wellenleitersegment (R) und das auf der von der Hochfrequenzbaugruppe (5) abgewandten Seite der Verzweigung (23) parallel zur Ausbreitungsrichtung verlaufende Wellenleitersegment (S) auf deren Unterseite jeweils einen kreisförmigen Abschluss (27) aufweisen.

16. Leiterplatte nach Anspruch 10, **dadurch gekennzeichnet, dass** Durchkontaktierungen (P) vorgesehen, über die die Metallisierung (15) auf der Oberseite der Leiterplattenlage (3) leitend mit der darunter befindlichen Metallisierung (17) auf der Unterseite der Leiterplattenlage (3) verbunden sind.

17. Leiterplatte nach Anspruch 16, **dadurch gekennzeichnet, dass** Auf den der weiteren Baugruppe (7) zugewandten Seiten der quer zur Ausbreitungsrichtung der Störwellen verlaufenden Wellenleitersegmente (R, U) unmittelbar an diese Wellenleitersegmente (R, U) angrenzende durchkontaktierungsfreie Bereichen (29) vorgesehen sind.

18. Leiterplatte nach Anspruch 10, **dadurch gekennzeichnet, dass** zwischen der Hochfrequenzbaugruppe (5) und der Wellenleiteranordnung (13) auf der Unterseite der Leiterplattenlage (3) ein metallisierungsfreier Bereich (19) vorgesehen ist.

## Claims

1. Printed circuit board (1) with
- a printed circuit layer (3) on which a high-frequency assembly (5), which, during operation, emits high-frequency electromagnetic interference waves, and at least an additional assembly (7), particularly another high-frequency assembly, are provided
**characterized in that**
- at least a dielectric disturber (9a, 9b) is provided between the high-frequency assembly (5) and the additional assembly (7), said disturber disturbing a propagation of the high-frequency electromagnetic interference waves between the high-frequency assembly (5) and the additional assembly (7), and
- **in that** an additional printed circuit layer (31) is provided under the printed circuit layer (3) and is made from a material that attenuates high-frequency electromagnetic waves, particularly glass-fiber matting soaked in epoxy resin.

2. Printed circuit board as claimed in Claim 1, **characterized in that** at least one dielectric disturber (9a) is a body, positioned on a top side of the printed circuit layer (3), said body being made from a dielectric, particularly a dielectric core of a component placed on a metal conductor path (11) on the top side of the printed circuit layer (3), particularly a resistor or a capacitor.

3. Printed circuit board as claimed in Claim 1, **characterized in that** at least one dielectric disturber (9a) is a dielectric waveguide arrangement (13) arranged in the printed circuit layer (3).

4. Printed circuit board as claimed in Claim 3, **characterized in that** the dielectric waveguide arrangement (13) has at least a waveguide segment (R, U) that is perpendicular to a direction of propagation of the interference waves.

5. Printed circuit board as claimed in Claim 3, **characterized in that** the waveguide arrangement (13) comprises waveguide segments (R, S, T, U) that are interconnected via a junction (23),
- wherein of said segments two are interconnected in a straight line via the junction (23) and extend in a manner that is perpendicular to a direction of propagation of the interference waves, and
- wherein of said segments two are interconnected in a straight line via the junction and extend in a manner that is parallel to a direction of propagation of the interference waves.

6. Printed circuit board as claimed in Claim 5, **characterized in that**
- during operation, interference waves that enter into the waveguide arrangement (13) via the waveguide segment (T), which runs parallel to the direction of propagation of the interference waves and faces towards the high-frequency assembly (5), are split at the junction (23) into subwaves that propagate in the remaining waveguide segments (R, S, U)
- these subwaves are reflected at the ends of the waveguide segments (R, S, T, U), and
- the waveguide segments (R, S, T, U) have predefined lengths depending on a predefined main frequency of the interference waves, wherein at said lengths subwaves of the main-frequency interference waves that occur overlap in a destructive manner with subwaves reflected at the ends of the waveguide segments (R, S, T, U) in the waveguide arrangement (13).

7. Printed circuit board as claimed in Claim 6, **characterized in that**
- the waveguide segments (R, U) that extend in a perpendicular manner to the direction of propagation of the interference waves have a length that corresponds to a half wavelength of the interference waves that have the main frequency in these waveguide segments (R, U), and
- the waveguide segments (S, T) that extend in a parallel manner to the direction of propagation of the interference waves have a length that corresponds to a quarter wavelength of the interference waves that have the main frequency in these waveguide segments (S, T).

8. Printed circuit board as claimed in Claim 6, **characterized in that** the waveguide arrangement (13) has an entry (21) facing towards the high-frequency assembly (5), which enters into the waveguide segment (T) that faces towards the high-frequency assembly (5) and extends in a parallel manner to the direction of propagation of the interference waves.

9. Printed circuit board as claimed in Claim 6, **characterized in that** the waveguide segments (S, T) connected in a straight line to the entry (23) have a lower impedance than the remaining waveguide segments (R, U).

10. Printed circuit board as claimed in Claim 3, **characterized in that** the waveguide arrangement (13) is formed by an area of the printed circuit layer (3) in which
- a metallization (15, 17) is applied on the top side and on the underside of the printed circuit layer (3),
- the metallizations (15, 17) each have a structure that is formed by recesses in the metallization, and
- the structures form the waveguide arrangement (13) in conjunction with the areas of the printed circuit layer (3) that are enclosed between them.

11. Printed circuit board as claimed in Claim 10, **characterized in that** the metallizations (15, 17) are made from metal surfaces (15a, 15b, 15c, 15d, 17a, 17b, 17c, 17d) that are spaced at a distance from one another.

12. Printed circuit board as claimed in Claim 10, **characterized in that** the metallic surfaces (17a, 17b, 17c, 17d) of one of the metallizations (17), particularly the metallic surfaces (17a, 17b, 17c, 17d) of the metallization (17) provided on the underside of the printed circuit layer (3), are interconnected in a conductive manner by means of bridges (25) applied on the printed circuit layer (3) outside the waveguide arrangement (13).

13. Printed circuit board as claimed in Claim 8 and 10, **characterized in that** the entry (21) is formed by recesses in the metallization (17) on the underside of the printed circuit layer (3).

14. Printed circuit board as claimed in Claim 5, **characterized in that** one of the waveguide segments (R) that runs perpendicular to the direction of propagation of the interference waves and the waveguide segment (S) that runs parallel to the direction of propagation on the side of the junction (23) facing away from the high-frequency assembly (5) are designed in such a way that they feature a slightly shorter length on their top side than on their underside.

15. Printed circuit board as claimed in Claim 14, **characterized in that** the waveguide segment (R) that runs perpendicular to the direction of propagation of the interference waves and the waveguide segment (S) that runs parallel to the direction of propagation on the side of the junction (23) facing away from the high-frequency assembly (5) each have a circular termination (27) on their underside.

16. Printed circuit board as claimed in Claim 10, **characterized in that** vias (P) are provided by means of which the metallization (15) on the top side of the printed circuit layer (3) is connected in a conductive manner to the metallization (17) located below this on the underside of the printed circuit layer (3).

17. Printed circuit board as claimed in Claim 16, **characterized in that** via-free areas (29) are provided on the sides of the waveguide segments (R, U) that run perpendicular to the direction of propagation of the interference waves, said sides facing towards the additional assembly (7), wherein said via-free areas are directly adjacent to these waveguide segments (R, U).

18. Printed circuit board as claimed in Claim 10, **characterized in that** a metallization-free area (19) is provided between the high-frequency assembly (5) and the waveguide arrangement (13) on the underside of the printed circuit layer (3).

## Revendications

1. Carte de circuit imprimé (1) avec
- une couche de circuit imprimé (3), sur laquelle sont prévus un composant haute fréquence (5) émettant, en fonctionnement, des ondes électromagnétiques perturbatrices de haute fréquence, et au moins un composant supplémentaire (7), notamment un autre composant haute fréquence,
**caractérisé**
- **en ce qu'**est prévu, entre le composant haute fréquence (5) et le composant supplémentaire (7), au moins un perturbateur diélectrique (9a, 9b), qui perturbe une propagation des ondes électromagnétiques perturbatrices de haute fréquence entre le composant haute fréquence (5) et le composant supplémentaire (7), et
- **en ce qu'**est prévu, sous la couche de circuit imprimé (3), un couche de circuit imprimé supplémentaire (31) constituée d'un matériau amortissant les ondes électromagnétiques de haute fréquence, notamment des nattes de fibres de verre imprégnées de résine époxy.

2. Carte de circuit imprimé selon la revendication 1, **caractérisée en ce qu'**un perturbateur diélectrique (9a) est un corps placé sur une face supérieure de la couche de circuit imprimé (3), lequel corps est constitué d'un diélectrique, notamment un noyau diélectrique d'un composant placé sur une piste métallique (11) sur la face supérieure de la couche de circuit imprimé (3), notamment une résistance ou un condensateur.

3. Carte de circuit imprimé selon la revendication 1, **caractérisée en ce qu'**au moins un perturbateur diélectrique (9a) est un dispositif de guide d'ondes diélectrique (13), disposé dans la couche de circuit imprimé (3).

4. Carte de circuit imprimé selon la revendication 3, **caractérisée en ce que** le dispositif de guide d'ondes diélectrique (13) présente au moins un segment de guide d'ondes (R, U) s'étendant perpendiculairement à une direction de propagation des ondes perturbatrices.

5. Carte de circuit imprimé selon la revendication 3, **caractérisée en ce que** le dispositif de guide d'ondes (13) comprend des segments de guide d'ondes (R, S, T, U) reliés entre eux via une dérivation (23),
- segments parmi lesquels deux sont reliés entre eux en ligne droite via la dérivation (23) et s'étendent perpendiculairement à une direction de propagation des ondes perturbatrices, et
- segments parmi lesquels deux sont reliés entre eux en ligne droite via la dérivation (23) et s'étendent parallèlement à une direction de propagation des ondes perturbatrices.

6. Carte de circuit imprimé selon la revendication 5, **caractérisée en ce que**
- en fonctionnement, les ondes perturbatrices - entrant dans le dispositif de guide d'ondes (13) au niveau de la dérivation (23) via le segment de guide d'ondes (T) faisant face au composant haute fréquence (5) et s'étendant parallèlement à la direction de propagation des ondes perturbatrices - sont divisées au niveau de la dérivation (23) en ondes partielles se propageant dans les segments de guide d'ondes (R, S, U) restants,
- ces ondes partielles sont réfléchies aux extrémités des segments de guide d'ondes (R, S, T, U), et
- les segments de guide d'ondes (R, S, T, U) présentent des longueurs prédéfinies en fonction d'une fréquence principale prédéfinie des ondes perturbatrices, longueurs auxquelles des ondes partielles d'ondes perturbatrices entrantes de la fréquence principale se superposent de manière destructive dans le dispositif de guide d'ondes (13) avec des ondes partielles réfléchies aux extrémités des segments de guide d'ondes (R, S, T, U).

7. Carte de circuit imprimé selon la revendication 6, **caractérisée en ce que**
- les segments de guide d'ondes (R, U) s'étendant perpendiculairement à la direction de propagation des ondes perturbatrices présentent une longueur correspondant à la moitié d'une longueur d'onde des ondes perturbatrices ayant la fréquence principale dans ces segments de guide d'ondes (R, U), et
- les segments de guide d'ondes (S, T) s'étendant parallèlement à la direction de propagation des ondes perturbatrices présentent une longueur correspondant à un quart de la longueur d'onde des ondes perturbatrices ayant la fréquence principale dans ces segments de guide d'ondes (S, T).

8. Carte de circuit imprimé selon la revendication 6, **caractérisée en ce que** le dispositif de guide d'ondes (13) présente une entrée (21) tournée vers le composant haute fréquence (5), qui débouche dans le segment de guide d'ondes (T) tourné vers le composant haute fréquence (5) et s'étendant parallèlement à la direction de propagation des ondes perturbatrices.

9. Carte de circuit imprimé selon la revendication 6, **caractérisée en ce que** les segments de guide d'ondes (S, T) connectés en ligne droite à l'entrée (23) présentent une impédance plus faible que les autres segments de guide d'ondes (R, U).

10. Carte de circuit imprimé selon la revendication 3, **caractérisée en ce que** le dispositif de guides d'ondes (13) est formé par une zone de la couche de circuit imprimé (3), dans laquelle
- une métallisation (15, 17) est appliquée respectivement sur la face supérieure et sur la face inférieure de la couche de circuit imprimé (3),
- les métallisations (15, 17) présentent chacune une structure formée par des évidements dans la métallisation, et
- les structures, associées aux zones de la couche de circuit imprimé (3) enfermées entre elles, forment le dispositif de guides d'ondes (13).

11. Carte de circuit imprimé selon la revendication 10, **caractérisée en ce que** les métallisations (15, 17) sont constituées de surfaces métalliques (15a, 15b, 15c, 15d, 17a, 17b, 17c, 17d) spatialement séparées les unes des autres.

12. Carte de circuit imprimé selon la revendication 10, **caractérisée en ce que** les surfaces métalliques (17a, 17b, 17c, 17d) de l'une des métallisations (17), notamment les surfaces métalliques (17a, 17b, 17c, 17d) de la métallisation (17) prévue sur la face inférieure de la couche de circuit imprimé (3), sont reliées entre elles de manière conductrice par des ponts (25) appliqués sur la couche de circuit imprimé (3) à l'extérieur du dispositif de guides d'ondes (13).

13. Carte de circuit imprimé selon la revendication 8 et 10, **caractérisée en ce que** l'entrée (21) est formée par des évidements dans la métallisation (17) sur la face inférieure de la couche de circuit imprimé (3).

14. Carte de circuit imprimé selon la revendication 5, **caractérisée en ce que** l'un des segments de guide d'ondes (R) s'étendant perpendiculairement à la direction de propagation des ondes perturbatrices et le segment de guide d'ondes (S) s'étendant parallèlement à la direction de propagation sur le côté de la dérivation (23) situé à l'opposé du composant haute fréquence (5) sont conçus de telle manière qu'ils présentent une longueur légèrement plus courte sur leur face supérieure que sur leur face inférieure.

15. Carte de circuit imprimé selon la revendication 14, **caractérisée en ce que** le segment de guide d'ondes (R) s'étendant perpendiculairement à la direction de propagation des ondes perturbatrices et le segment de guide d'ondes (S) s'étendant parallèlement à la direction de propagation sur le côté de la dérivation (23) situé à l'opposé du composant haute fréquence (5) présentent chacun une terminaison circulaire (27) sur leur face inférieure.

16. Carte de circuit imprimé selon la revendication 10, **caractérisée en ce que** des trous traversants (P) sont prévus, par l'intermédiaire lesquels la métallisation (15) sur la face supérieure de la couche de circuit imprimé (3) est reliée de manière conductrice à la métallisation (17) située en dessous sur la face inférieure de la couche de circuit imprimé (3).

17. Carte de circuit imprimé selon la revendication 16, **caractérisée en ce que** sur les côtés des segments de guide d'ondes (R, U) s'étendant perpendiculairement à la direction de propagation des ondes perturbatrices sont prévues des zones (29) exemptes de trous traversants, qui font face au composant supplémentaire (7), directement adjacent à ces segments de guide d'ondes (R, U).

18. Carte de circuit imprimé selon la revendication 10, **caractérisée en ce qu'**est prévue, entre le composant haute fréquence (5) et le dispositif de guide d'ondes (13), une zone exempte de métallisation (19) sur le dessous de la couche de circuit imprimé (3).
